(19) Europäisches Patentamt
European Patent Office
Office européen des brevets

(11) **EP 2 689 528 B1**

(12) **EUROPÄISCHE PATENTSCHRIFT**

(45) Veröffentlichungstag und Bekanntmachung des Hinweises auf die Patenterteilung:
**12.11.2014 Patentblatt 2014/46**

(21) Anmeldenummer: **12716175.0**

(22) Anmeldetag: **21.03.2012**

(51) Int Cl.:
*H02P 21/00* (2006.01)     *H02M 1/00* (2007.01)
*G01R 33/00* (2006.01)     *G01R 35/00* (2006.01)

(86) Internationale Anmeldenummer:
**PCT/AT2012/000072**

(87) Internationale Veröffentlichungsnummer:
**WO 2012/126029 (27.09.2012 Gazette 2012/39)**

(54) **VERFAHREN UND VORRICHTUNG ZUR KORREKTUR VON STRANGSTRÖMEN EINER DREHSTROMMASCHINE**

METHOD AND APPARATUS FOR CORRECTING PHASE CURRENTS OF A THREE-PHASE MACHINE

PROCÉDÉ ET DISPOSITIF POUR CORRIGER DES COURANTS DE PHASE D'UNE MACHINE TRIPHASÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.03.2011 AT 3972011**

(43) Veröffentlichungstag der Anmeldung:
**29.01.2014 Patentblatt 2014/05**

(73) Patentinhaber: **Kristl, Seibt & Co. Gesellschaft m.b.H.**
**8052 Graz (AT)**

(72) Erfinder:
• **BAUER, Robert**
**A-8041 Graz (AT)**
• **BUCH, Norbert**
**A-8054 Seiersberg (AT)**
• **SCHLICHTNER, Bernhard**
**A-6353 Going (AT)**
• **SOMMER, Wolfgang**
**A-8410 Wildon (AT)**

(74) Vertreter: **Sonn & Partner Patentanwälte**
**Riemergasse 14**
**1010 Wien (AT)**

(56) Entgegenhaltungen:
EP-A1- 2 058 936     JP-A- 10 080 008
JP-A- 2009 281 772     JP-A- 2010 110 067
US-A1- 2005 184 156

EP 2 689 528 B1

**Beschreibung**

Die Erfindung betrifft ein Verfahren zur Korrektur von Strangströmen einer Drehstrommaschine, wobei mit Verstärkungs-und/oder mit Offsetfehlern behaftete Messwerte der Strangströme erfasst werden, die zur Regelung der Strangströme herangezogen werden und im Betrieb der Drehstrommaschine aus den Messwerten der Strangströme Korrekturparameter zur Korrektur der Verstärkungs- bzw. Offsetfehler berechnet werden, wobei mit den Korrekturparametern korrigierte Strangströme bestimmt werden, die an die Regelung der Strangströme übergeben werden, sowie eine Vorrichtung zur Korrektur von Strangströmen einer Drehstrommaschine, mit einer Messeinrichtung zum Messen von mit Verstärkungs-und/oder mit Offsetfehlern behafteten Strangströmen einer Drehstrommaschine, und mit einer mit der Messeinrichtung verbundenen Regeleinrichtung zur Regelung der Strangströme.

Drehstrommaschinen, welche als Asynchron- oder Synchronmaschinen ausgeführt sein können, werden mit Dreiphasenwechselstrom bzw. Drehstrom betrieben, welcher in drei getrennten Leitern jeweils einen eigenen Wechselstrom führt. Die Wechselströme in den Leitern sind zueinander um 120° in der Phase versetzt. Die Drehstrommaschine weist drei Anschlüsse bzw. Stränge auf, an die der Drehstrom angelegt wird. Um die Drehzahl (bzw. das Drehmoment) der Drehstrommaschine im Betrieb regeln zu können, wird die Drehstrommaschine üblicherweise von einem Frequenzumrichter gespeist. Der Frequenzumrichter weist einen Wechselrichter auf, der die Strangspannungen bzw. -ströme aus einer konstanten Zwischenkreisspannung erzeugt, die durch Gleichrichtung aus einem öffentlichen Drehstromnetz gewonnen werden kann. Der Wechselrichter arbeitet mit Leistungsschaltern, die über einen entsprechenden Algorithmus, beispielsweise eine feldorientierte Regelung (FOC, "field oriented control"), derart angesteuert werden, dass an den Strängen der Drehstrommaschine die gewünschten Strangströme auftreten. Zur Regelung der Drehstrommaschine werden laufend Messwerte der Strangströme erfasst, die an die Regelung übergeben werden. Die Messwerte der Strangströme sind zwangsläufig mit Verstärkungs- und/oder Offsetfehlern behaftet, so dass die an die Regelung der Strangströme überlieferten Messwerte von den realen Strangströmen abweichen können. Die Verstärkungsfehler stellen dabei einen zum Strom proportionalen Fehleranteil dar. Die Offsetfehler (auch als Nullpunktfehler bezeichnet) bewirken eine Verschiebung zwischen den realen Strangströmen und den gemessenen Strangströmen. Die fehlerhafte Strommessung wirkt sich insbesondere durch einen im Betrieb der Drehstrommaschine unerwünschten Drehmomentrippel, d.h. eine Welligkeit im Verlauf des Drehmoments, aus. Ein reiner Verstärkungsfehler bewirkt dabei einen Drehmomentrippel mit doppelter Drehstrom-Frequenz. Ein reiner Offsetfehler ruft einen Drehmomentrippel mit einfacher Drehstrom-Frequenz hervor. Wenn die Messwerte der Strangströme sowohl Verstärkungs- als auch Offsetfehler aufweisen, wird ein Drehmomentrippel mit zwei Spektralanteilen, nämlich mit einfacher und doppelter Drehstrom-Frequenz, erhalten.

Aus der US 2009/0189553 A1 ist ein Verfahren zur Regelung einer Drehstrommaschine bei Hybridfahrzeugen bekannt. Die Maschine wird mit einer Regeleinheit angesteuert, welche einen Schaltkreis zur Regelung der Verstärkungsfaktoren der Strangströme aufweist. Die Strangströme werden mittels Sensoren gemessen, woraus Verstärkungs-Korrekturfaktoren für die Strangströme gebildet werden. Zur Bestimmung des Verstärkungs-Korrekturfaktors für den ersten Sensor werden die Messgrößen des ersten und dritten Sensors herangezogen. Der Verstärkungs-Korrekturfaktor für den zweiten Sensor wird aus den Messgrößen für den zweiten bzw. dritten Strangstrom-Sensor bestimmt. Hierbei wird eine Abweichung zwischen dem Mittelwert der gemessenen Stromamplitude in den jeweiligen Strängen und einer vorgegebenen Amplitude als Regelgröße herangezogen. Demnach ist es aus diesem Stand der Technik bekannt, reine Verstärkungsfehler der Strangstrom-Sensoren in Echtzeit unter wechselnden Bedingungen zu reduzieren. Das bekannte Korrekturverfahren weist jedoch eine Reihe von Einschränkungen auf. Nachteiligerweise ist bei diesem Verfahren einerseits ein weiterer, hochgenauer und daher kostspieliger Stromsensor für den dritten Strangstrom zwingend erforderlich. Weiters muss die elektrische Kreisfrequenz in einem bestimmten Bereich liegen und die Drehstrommaschine muss über weite Strecken stationär betrieben werden, da ansonsten die notwendige Filterung der Zwischengrößen, d.h. der Amplituden der entsprechenden Strangströme, nicht durchgeführt werden kann. Wird die Drehstrommaschine hochdynamisch betrieben, können die Korrekturwerte nicht im Normalbetrieb bestimmt werden. Demnach ist das Einsatzgebiet des bekannten Verfahrens nachteiligerweise stark eingeschränkt. Zudem werden bei dem bekannten Verfahren ausschließlich Verstärkungsfehler der Messsensoren berücksichtigt. Somit ist der Stand der Technik nicht dazu in der Lage, eine dynamische, komplexe Fehlerstruktur in der Messung der Strangströme auszugleichen.

In der JP 2009/303283 A ist weiters ein Verfahren zur Steuerung eines Drehstrommotors beschrieben, bei welchem bei Überschreitung einer maximalen Stromdifferenz das Vorhandensein eines Offsetfehlers erkannt wird. Nachteiligerweise können jedoch vorhandene Verstärkungsfehler das Verfahren massiv beeinflussen. Somit ist auch dieses Verfahren nicht dazu geeignet, die bei hochdynamischen Prozessen auftretenden Fehler zuverlässig zu kompensieren.

Im Stand der Technik ist es weiters bekannt, vor dem eigentlichen Betrieb der Drehstrommaschine Verstärkungsfaktoren und Offsetwerte der verwendeten Messfühler experimentell zu bestimmen, um daraus resultierende Verstärkungs- bzw. Offsetfehler zu verhindern. Die Verstärkungsfaktoren und Offsetwerte der Messfühler können sich jedoch im laufenden Betrieb der Drehstrommaschine ändern, so dass eine einmalige Kalibrierung der Messfühler - vor Inbetriebnahme der Drehstrommaschine - in den wenigsten Fällen zielführend ist.

In der US 2008/265829 A1 ist eine Umrichteranordnung zur Ansteuerung eines Dreiphasen-Motors offenbart, welche eine Strangstrom-Korrektureinheit aufweist, um Fehler zwischen den gemessenen Strangströmen auszugleichen. Die gemessenen Strangströme werden an die Korrektureinheit übergeben, welche korrigierte Strangströme bildet, aus welchen die Strangspannungen gebildet werden. Hierbei werden die Verstärkungsfehler bei der Strommessung vor dem eigentlichen Betrieb durch eine Identifikationsprozedur mit speziellen Schalterstellungen im Frequenzumrichter ermittelt. Im Normalbetrieb werden die gefundenen - konstanten - Korrekturwerte zur Korrektur der Verstärkungsfehler eingesetzt. Demnach kann bei diesem Stand der Technik nachteiligerweise keine Anpassung der Korrekturwerte im Normalbetrieb erfolgen. Somit können die Änderungen der Messfehler im Betrieb nicht berücksichtigt werden.

In der JP 2005/318739 A ist ein ähnliches Verfahren wie in der US 2008/265829 A1 beschrieben, welches die gleichen Nachteile bzw. Einschränkungen aufweist.

Im Stand der Technik sind zudem verschiedenste Parameter-Schätzverfahren bekannt, um die sich im laufenden Betrieb ändernden Parameter von Drehfeldmaschinen abzuschätzen. Hierfür wurde jedoch bislang von identischen Strangströmen an den einzelnen Strängen der Drehstrommaschine ausgegangen, indem Abweichungen zwischen den Messwerten der einzelnen Strangströme vernachlässigt werden. Ein Beispiel dafür ist die DE 41 107 16 A1, welche sich mit der Modifikation einer Rotarzeitkonstante einer Asynchronmaschine beschäftigt. Hierfür werden u.a. Statorspannung und Statorstrom als Eingangsgrößen für ein Parameter-Schätzverfahren herangezogen. Das Parameter-Schätzverfahren, welches die Methode der kleinsten Fehlerquadrate verwendet, geht von einem identischen Statorwiderstand für die drei Stränge der Asynchronmaschine aus, so dass prinzipbedingt Messfehler in den einzelnen Strängen nicht berücksichtigt werden können.

Die EP 2 058 936 zeigt eine Umrichteranordnung mit einem Umrichter, der von einer Regelungsschaltung angesteuert wird. Die Regelungsschaltung ist mit Stromsensoren an zwei der drei Drehstromphasen einer Phasenerkennungseinrichtung sowie einem Verstärker zur Messung der an einem Messwiderstand abfallenden Spannung verbunden. Zur Offsetkorrektur werden jeweils phasenabhängig über zwei Halbwellen gebildete Gleichrichtwerte verglichen und die Differenz der beiden Halbwellen-Gleichrichtwerte als Offsetkorrekturkomponente verwendet. Die Amplitudenkorrektur basiert auf einem Vergleich der eingangs- und ausgangsseitigen Gleichrichtwerte für eine vollständige Schwingungsperiode.

Die JP 2010 110067 zeigt eine Schaltung zur Steuerung eines Drehstrommotors und ein Verfahren zur Ermittlung von Korrekturparameter im Betrieb. Dabei werden in einem Abstand von 60° Phasenwinkel immer ein Amplituden-Korrekturwert und zwei Offset-Korrekturwerte ermittelt.

Die Aufgabe der vorliegenden Erfindung besteht darin, ein Verfahren bzw. eine Vorrichtung, wie oben angegeben, zu schaffen, mit welchem bzw. mit welcher die nachteiligen Auswirkungen einer fehlerbehafteten Messung der Strangströme auf die Regelung der Drehstrommaschine auf einfache, effiziente und rasche Weise reduziert werden können, wobei insbesondere das Auftreten von Drehmomentrippeln im Betrieb der Drehstrommaschine verringert bzw. vermieden werden soll.

Diese Aufgabe wird beim Verfahren der eingangs angeführten Art nach Anspruch 1 dadurch gelöst, dass im Betrieb der Drehstrommaschine aus den Messwerten der Strangströme mittels eines rekursiven Algorithmus Korrekturparameter zur Korrektur der Verstärkungs- bzw. Offsetfehler berechnet werden, wobei mit den Korrekturparametern korrigierte Strangströme bestimmt werden, die an die Regelung der Strangströme übergeben werden. Demnach werden die aktuellen Korrekturparameter bevorzugt dadurch bestimmt, dass die aktuellen Messwerte der Strangströme mit den in vorangehenden Zeitschritten berechneten Korrekturparametern verknüpft werden. Jeder Zeitschritt entspricht dabei vorzugsweise einer Messung der Strangströme zu einem bestimmten Zeitpunkt. Hierdurch kann die Berechnung der Korrekturparameter erheblich vereinfacht werden, da auf die Ergebnisse früherer Berechnungen zurückgegriffen werden kann. Zudem kann eine Reduktion der Rechenzeit erreicht werden. Eine bevorzugte Implementierung des rekursiven Algorithmus sieht vor, dass ausschließlich die Korrekturparameter des vorangehenden Schrittes zur Berechnung der aktuellen Korrekturparameter herangezogen werden.

Demnach werden im laufenden Betrieb der Drehstrommaschine erfasste Messwerte der Strangströme dazu verwendet, Korrekturparameter für die Strangströme zu bestimmen. Die Korrekturparameter werden mit den fehlerbehafteten Messwerten der Strangströme zu korrigierten Strangströmen verknüpft, welche an die Regelung der Strangströme übergeben werden. Da auf Basis der Korrekturparameter korrigierte Strangströme gebildet werden, die der Regelung der Strangströme zugrundegelegt werden, können die negativen Auswirkungen von Messfehlern weitestgehend behoben werden. Die Korrektur der gemessenen Strangströme birgt insbesondere den Vorteil, dass das von der Drehstrommaschine bereitgestellte Drehmoment eine geringere Welligkeit aufweist, indem Drehmomentrippel reduziert oder gänzlich vermieden werden. Zur Korrektur der Verstärkungs- bzw. Offsetfehler ist insbesondere vorgesehen, dass für jeden Strangstrom ein eigener Korrekturparameter bestimmt wird, um die korrigierten Strangströme zu erhalten. Hierfür werden die Strangströme vorzugsweise an jedem Strang der Drehstrommaschine einzeln gemessen. Demnach können Abweichungen zwischen den einzelnen Strangströmen gezielt durch die zugehörigen Korrekturparameter berücksichtigt werden. Zudem können vorteilhafterweise auch solche Messfehler korrigiert werden, die erst im Betrieb der Drehstrommaschine auftreten oder sich im laufenden Betrieb der Drehstrommaschine verändern, so dass eine vorangehende Kalibrierung der Strommessung nicht ausreichend wäre. Wie eingangs erwähnt, können die Messfehler in der Messung der Strangströme Verstärkungs- und/oder Offset-Anteile aufweisen. Im Fall eines reinen Verstärkungsfehlers werden zweckmäßigerweise drei Korrekturparameter (je ein Korrekturparameter pro Strangstrom) bestimmt, wobei vorzugsweise ein Korrekturparameter durch Anwendung der Kirchhoff'schen Knotenregel vorgegeben wird; die Anzahl der Korrekturparameter erhöht sich bei Auftreten von Offsetfehlern entsprechend.

Da die Messfehler der Strangströme im Betrieb der Drehstrommaschine typischerweise ständigen Veränderungen unterliegen, ist es günstig, wenn zur laufenden Anpassung der Korrekturparameter im Betrieb der Drehstrommaschine eine zeitliche Abfolge von Messwerten der Strangströme verarbeitet wird. Demnach werden die Strangströme laufend überwacht, um aus den Messwerten der Strangströme die einzelnen Korrekturparameter zu bilden, welche zur Berechnung korrigierter Strangströme für die Regelung der Drehstrommaschine genutzt werden.

Damit die Strangströme sensibel und rasch an Veränderungen in den Messwerten der Strangströme angepasst werden können, ist es von Vorteil, wenn für die Berechnung der Korrekturparameter eine zeitliche Gewichtung der Messwerte der Strangströme vorgenommen wird, wobei aktuelle Messwerte der Strangströme stärker als frühere Messwerte der Strangströme gewichtet werden. Die Korrekturparameter werden laufend, zweckmäßigerweise nach jeder Messung der Strangströme, angepasst, wobei vorzugsweise den jüngsten Messwerten das höchste Gewicht beigemessen wird.

Damit der rekursive Algorithmus Veränderungen in den gemessenen Strangströmen präzise und zeitnah abbilden kann, ist es von Vorteil, wenn als rekursiver Algorithmus eine Methode der kleinsten Fehlerquadrate, vorzugsweise mit einem Vergessensfaktor zur zeitlichen Gewichtung der Messwerte der Strangströme, verwendet wird. In der Praxis hat sich insbesondere der Algorithmus auf Basis kleinster Fehlerquadrate mit Vergessensfaktor als vorteilhaft herausgestellt. Der Vergessensfaktor, welcher dem Algorithmus als Eingangsgröße übergeben wird, ist ein Maß dafür, wie lange bestimmte Messwerte der Strangströme in der Berechnung der Korrekturparameter berücksichtigt werden.

Zur Regelung der Drehstrommaschine, insbesondere im Hinblick auf ein vorgegebenes Drehmoment, ist es günstig, wenn die korrigierten Strangströme an eine feldorientierte Regelung der Strangströme übergeben werden. Die feldorientierte Regelung erhält die korrigierten Strangströme als Eingangsgröße. In der feldorientierten Regelung werden die korrigierten Strangströme in das Rotorfluss-Koordinatensystem (d-q-Koordinatensystem) umgerechnet, welches den Vorteil aufweist, dass die Strangströme im stationären Zustand der Drehstrommaschine bezogen auf die Rotorfluss-Koordinaten konstant - und somit leicht regelbar - sind. Die korrigierten Strangströme werden vor Übermittlung an die Regelung zweckmäßigerweise in Stromraumzeiger-Koordinaten ($\alpha$-$\beta$-System) umgewandelt.

Die der Erfindung zugrundeliegende Aufgabe wird weiters durch eine Vorrichtung der eingangs angeführten Art nach Anspruch 7 gelöst, bei welcher die Messeinrichtung mit einer Recheneinheit verbunden ist, welche dazu eingerichtet ist, im Betrieb der Drehstrommaschine aus den Messwerten der Strangströme mittels eines rekursiven Algorithmus Korrekturparameter zur Korrektur der Verstärkungs- bzw. Offsetfehler zu berechnen, wobei die Recheneinheit zur Übertragung korrigierter Strangströme mit der Regeleinrichtung verbunden ist. Die hiermit erzielbaren Vorteile bzw. Effekte wurden im Zusammenhang mit dem zugehörigen Verfahren beschrieben, so dass auf die vorstehenden Ausführungen verwiesen werden kann.

Zur Erfassung der einzelnen Strangströme ist es günstig, wenn die Messeinrichtung jeweils einem Strang der Drehstrommaschine zugeordnete Stromsensoren, insbesondere Kompensationsstromwandler, zum Messen der zugehörigen Strangströme aufweist. Die Recheneinheit weist im Betrieb jedem Strangstrom einen eigenen Korrekturparameter zu; die Korrekturparameter werden zweckmäßigerweise nach jeder Messung der Strangströme angepasst.

Die Erfindung wird nachstehend anhand von in den Zeichnungen dargestellten Ausführungsbeispielen, auf die sie jedoch nicht beschränkt sein soll, noch weiter erläutert.

Im Einzelnen zeigen in der Zeichnung:

Fig. 1 eine schematische Ansicht einer umrichtergespeisten Drehstrommaschine, deren Strangströme gemessen werden;

Fig. 2a schematisch die Strangströme als Funktion der Zeit;

Fig. 2b schematisch die Strangströme nach Transformation in Stromraumzeiger-Koordinaten ($\alpha$-$\beta$-Koordinaten);

Fig. 3a schematisch den Stromraumzeiger gemäß Fig. 2b, welcher durch einen Verstärkungsfehler in der Messung der Strangströme verzerrt ist;

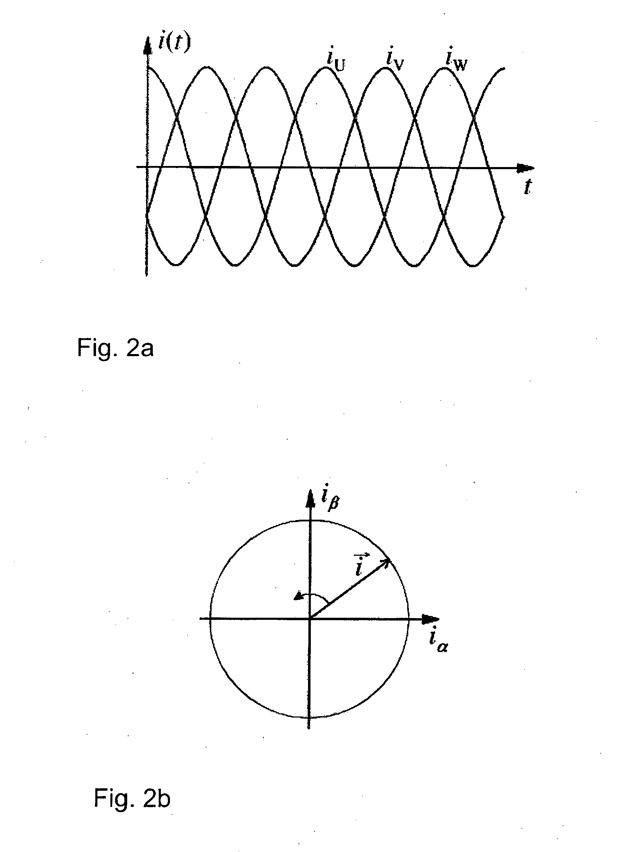

Fig..3b schematisch den Stromraumzeiger gemäß Fig. 2b, welcher durch einen Offsetfehler in der Strommessung aus dem Ursprung verschoben ist; und

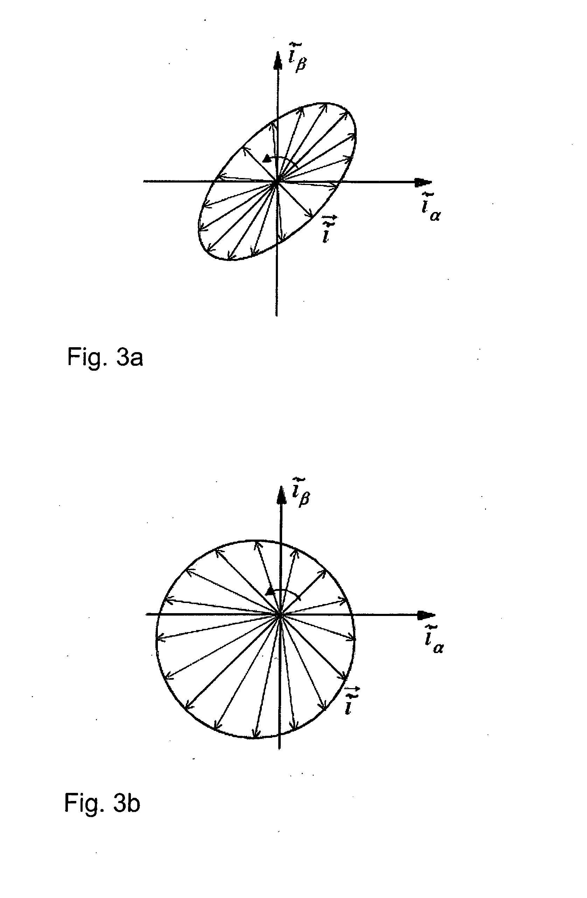

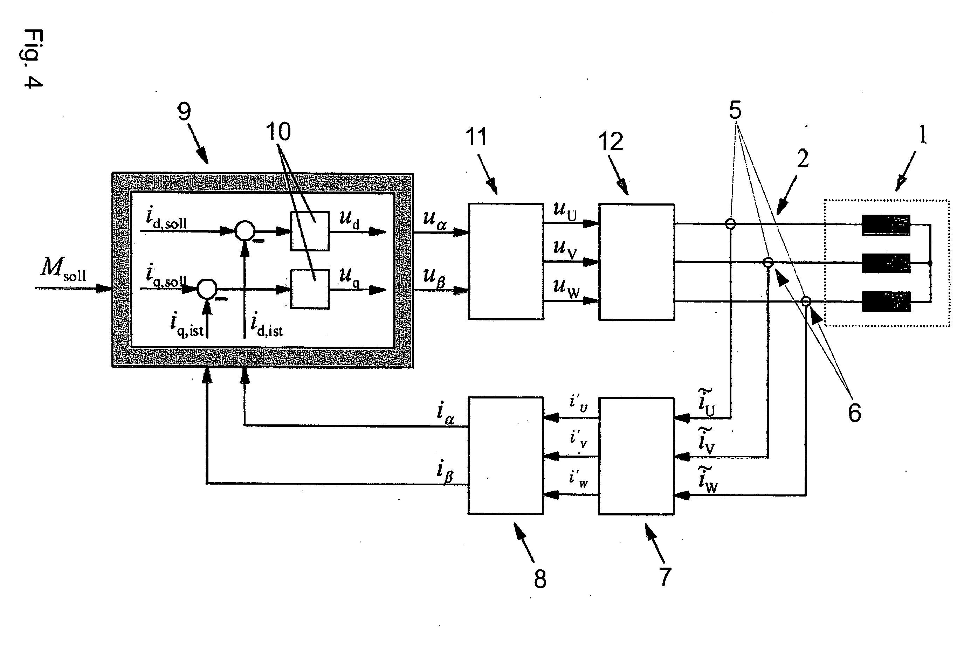

Fig. 4 ein erfindungsgemäßes Regelschema zur Korrektur der mit Verstärkungsfehlern nach Fig. 3a bzw. mit Offsetfehlern nach Fig. 3b behafteten Messwerte der Strangströme, wobei aus den Messwerten der Strangströme in einer Recheneinheit Korrekturparameter bestimmt werden, welche zur Berechnung korrigierter Strangströme für die Regelung der Strangströme herangezogen werden.

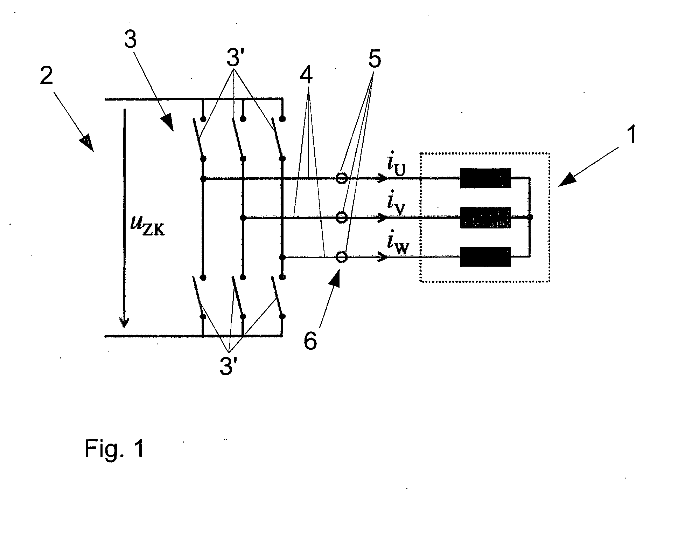

Fig. 1 zeigt schematisch die Anbindung einer Drehstrommaschine 1 an einen Frequenzumrichter 2. Die Drehstrommaschine 1 kann als Asynchron- oder Synchronmaschine ausgeführt sein, welche je nach Betriebsweise als Motor oder Generator arbeitet. Der Frequenzumrichter 2 weist einen Wechselrichter 3 auf, welcher an den insgesamt drei Strängen 4 der Drehstrommaschine 1 Strangsströme $i_U$, $i_V$, $i_W$ anlegt. Der Wechselrichter 3 erzeugt die Strangsströme $i_U$, $i_V$, $i_W$ aus einer konstanten Zwischenkreisspannung $u_{ZK}$, die beispielsweise durch Gleichrichtung aus einem öffentlichen Drehstromnetz (nicht gezeigt) gewonnen wird. Um die Drehstrommaschine 1 mit den Strangströmen $i_U$, $i_V$, $i_W$ zu versorgen, weist der Wechselrichter 3 Leistungsschalter 3' auf, die über einen entsprechenden Algorithmus, beispielsweise eine feldorientierte Regelung (FOC, "field oriented control") derart angesteuert werden, dass auf den Strängen 4 der Drehstrommaschine 1 die gewünschten Strangströme $i_U$, $i_V$, $i_W$ erzielt werden. Als Leistungsschalter können insbesondere Thyristoren, Metall-Oxid-Halbleiter-Feldeffekttransistoren (MOSFET), Bipolartransistoren mit isolierter Gate-Elektrode (IGBT), oder dergl. eingesetzt werden. Die Strangströme $i_U$, $i_V$, $i_W$ fließen durch die an der Drehstrommaschine 1 anliegenden Stränge.

In Fig. 1 sind weiters schematisch Stromsensoren 5 einer Messeinrichtung 6 zum Messen der Strangströme $i_U$, $i_U$, $i_W$ eingezeichnet. Die Messwerte der Strangströme $\tilde{i}_U$, $\tilde{i}_V$ und $\tilde{i}_W$ werden zur Regelung der Strangströme $i_U$, $i_V$, $i_W$ hinsichtlich eines vorgegebenen Sollwerts, insbesondere für das Drehmoment der Drehstrommaschine 1 (vgl. Fig. 4), herangezogen. Aufgrund der Kirchhoff'schen Knotenregel gemäß Gleichung (1) ist die Summe der Strangströme $i_U$, $i_V$, $i_W$ gleich Null.

$$i_U + i_V + i_W = 0 \qquad\qquad (1)$$

Demnach könnte ein Strangstrom $i_W$ aus den Messwerten der beiden anderen Strangströme $i_U$, $i_V$ berechnet werden. In der Praxis ist es jedoch zweckmäßig, wenn alle drei Strangströme $i_U$, $i_V$, $i_W$ gemessen werden.

Wie aus Fig. 2 ersichtlich, können die Strangströme $i_U$, $i_V$, $i_W$ mit einem in der Literatur zu Drehstrommaschinen 1 üblichen Stromraumzeiger $\vec{i}$ dargestellt werden, welcher Komponenten $i_\alpha$ und $i_\beta$ aufweist, die gemäß Gleichung (2) bzw. Gleichung (3) aus den Strangströmen $i_U$, $i_V$ und $i_W$ berechnet werden können.

$$i_\alpha = \frac{2}{3} i_U - \frac{1}{3} i_V - \frac{1}{3} i_W \qquad\qquad (2)$$

$$i_\beta = \frac{\sqrt{3}}{3} i_V - \frac{\sqrt{3}}{3} i_W \qquad\qquad (3)$$

Im stationären Zustand der Drehstrommaschine 1 mit konstanter Drehzahl und konstantem Drehmoment sind die sinusförmigen Strangströme $i_U$, $i_V$, $i_W$ um 120° zueinander in der Phase versetzt, während der Stromraumzeiger $\overline{i}$ mit konstanter Länge in Pfeilrichtung gleichförmig rotiert. Die Spitze des Stromraumzeigers i beschreibt dabei einen Kreis mit dem Ursprung des Koordinatensystems als Mittelpunkt. Somit kann die Darstellung des stationären Zustands der Drehstrommaschine 1 mit Hilfe des Stromraumzeigers $\overline{i}$ wesentlich vereinfacht werden.

Die gemessenen Strangströme $\tilde{i}_U$, $\tilde{i}_V$ und $\tilde{i}_W$ können die realen Strangströme $i_U$, $i_V$, $i_W$ nicht exakt abbilden, da die Messung der Strangströme $i_U$, $i_V$, $i_W$ mit Fehlern behaftet ist. Diese Fehler können für die einzelnen Strangströme $i_U$, $i_V$, $i_W$ verschieden sein; zudem können sich die Fehler während des Betriebs der Drehstrommaschine 1 ändern. Die Messwerte der Strangströme $\tilde{i}_U$, $\tilde{i}_V$ und $\tilde{i}_W$ hängen gemäß den Gleichungen (4), (5) und (6) über Verstärkungsfaktoren $k_U$, $k_V$, $k_W$ und Offsetwerte $d_U$, $d_V$, $d_W$ mit den wahren Strangströmen $i_U$, $i_V$ und $i_W$ zusammen.

$$\tilde{i}_U = k_U i_U + d_U \qquad\qquad (4)$$

$$\tilde{\imath}_V = k_V\, i_V + d_V \qquad\qquad (5)$$

$$\tilde{\imath}_W = k_W\, i_W + d_W \qquad\qquad (6)$$

Die Verstärkungsfaktoren $k_U$, $k_V$, $k_W$ bewirken zu den Strangströmen $i_U$, $i_V$ und $i_W$ proportionale Verstärkungsfehler. Die Offsetwerte $d_U$, $d_V$, $d_W$ rufen von den Strangströmen $i_U$, $i_V$ und $i_W$ unabhängige Offsetfehler hervor.

Wie aus Fig. 3a ersichtlich, bewirkt ein reiner Verstärkungsfehler in den gemessenen Strangströmen $\tilde{\imath}_U$, $\tilde{\imath}_V$ und $\tilde{\imath}_W$ eine Verformung der durch den Stromraumzeiger $\vec{i}$ beschriebenen Bahn in eine Ellipse, so dass pro Umdrehung des Stromraumzeigers $\vec{i}$ zwei Maxima und zwei Minima auftreten. Die Auswirkung eines solchen Verstärkungsfehlers sind in Fig. 3a übertrieben dargestellt.

Aus Fig. 3b ist ein Stromraumzeiger $\vec{i}$ ohne Verstärkungs-, aber mit einem Offsetfehler ersichtlich. Der Offsetfehler bewirkt eine Verschiebung des kreisförmig umlaufenden Stromraumzeigers $\vec{i}$ aus dem Ursprung des Koordinatensystems. Dies hat zur Folge, dass der Betrag des Stromraumzeigers $i$ pro Umdrehung ein Maximum und ein Minimum aufweist. Im Betrieb der Drehstrommaschine 1 ist die Messung der Strangströme $i_U$, $i_V$ und $i_W$ üblicherweise sowohl mit Verstärkungs- als auch mit Offsetfehlern behaftet, so dass die Bahn des Stromraumzeigers $\vec{i}$ eine Verformung und eine Verschiebung erfährt.

Die fehlerbehaftete Strommessung wirkt sich nachteilig auf die Regelung der Strangströme $i_U$, $i_V$ und $i_W$ aus, welche auf den Messwerten der Strangströme $\tilde{\imath}_U$, $\tilde{\imath}_V$ und $\tilde{\imath}_W$ beruht. Im stationären Zustand der Drehstrommaschine 1 zielt die Regelung der Strangströme $i_U$, $i_V$ und $i_W$ darauf ab, den gemessenen, mit Verstärkungs- bzw. Offsetfehlern behafteten Stromraumzeiger $\vec{i}$ an die gewünschte Kreisform anzugleichen, wodurch sich allerdings der wahre Stromraumzeiger $\vec{i}$ von der Kreisform entfernt. Da die Länge des Stromraumzeigers $\vec{i}$ und das Drehmoment der Drehstrommaschine 1 zusammenhängen, verursachen die fehlerbehafteten Messwerte der Strangströme einen Drehmomentrippel, d.h. eine dem Verlauf des Drehmoments überlagerte Welligkeit. Ein reiner Verstärkungsfehler bewirkt dabei einen Drehmomentrippel mit zwei Maxima und zwei Minima pro Umlauf des Stromraumzeigers $\vec{i}$, , d.h. eine Welligkeit mit doppelter Drehstrom-Frequenz. Ein reiner Offsetfehler bewirkt einen Drehmomentrippel mit einem Maximum und einem Minimum pro Umlauf, was einer Welligkeit mit einfacher Drehstrom-Frequenz entspricht. Wenn Verstärkungs- und Offsetfehler auftreten, wird ein Drehmomentrippel mit zwei Spektralanteilen erhalten.

Um die für den Betrieb der Drehstrommaschine 1 nachteiligen Drehmomentrippel zu verringern, werden die gemessenen Strangströme $\tilde{\imath}_U$, $\tilde{\imath}_V$ und $\tilde{\imath}_W$ erfindungsgemäß im laufenden Betrieb der Drehstrommaschine 1 korrigiert. Hierfür werden aus den Messwerten der Strangströme $\tilde{\imath}_U$, $\tilde{\imath}_V$ und $\tilde{\imath}_W$ Korrekturparameter $\alpha$ zur Korrektur der Verstärkungs- und/oder Offsetfehler berechnet. Auf Basis der Korrekturparameter $\alpha$ werden korrigierte Strangströme $i'_U$, $i'_V$, $i'_W$ bestimmt, die an die Regelung der Strangströme $i_U$, $i_V$, $i_W$ übergeben werden.

In Fig. 4 ist schematisch ein Regelschema zur Regelung der korrigierten Strangströme $i'_U$, $i'_V$, $i'_W$ dargestellt. Demnach liefern die Stromsensoren 5 der Messeinrichtung 6 fehlerbehaftete Messwerte der Strangströme $\tilde{\imath}_U$, $\tilde{\imath}_V$ und $\tilde{\imath}_W$ an eine Recheneinheit 7, welche die Korrekturparameter $\alpha$ bestimmt, die mit den gemessenen Strangströmen $\tilde{\imath}_U$, $\tilde{\imath}_V$ und $\tilde{\imath}_W$ zu den korrigierten Strangströmen $i'_U$, $i'_V$, $i'_W$ verknüpft werden. Die korrigierten Strangströme $i'_U$, $i'_V$, $i'_W$ werden mittels eines Konverters 8 in Stromraumzeiger-Komponenten $i_\alpha$ und $i_\beta$ umgerechnet (vgl. Fig. 2). Die als Stromraumzeiger $\vec{i}$ dargestellten, korrigierten Strangströme $i'_U$, $i'_V$, $i'_W$ werden einer feldorientierten Regeleinrichtung 9 übergeben, welche die Stromraumzeiger-Komponenten $i_\alpha$ und $i_\beta$ in Rotorfluss-Komponenten $i_{q,ist}$ und $i_{d,ist}$ transformiert. Die Regeleinrichtung 9 weist zwei Stromregler 10 zum Regeln der in das Rotorfluss-Koordinatensystem (d-q-System) transformierten Ist-Werte der Ströme $i_{q,\,ist}$ und $i_{d,\,ist}$ auf. Die Ist-Werte der Ströme $i_{q,\,ist}$ und $i_{d,\,ist}$ werden von den Stromreglern 10 mit Soll-Werten der Ströme $i_{q,soll}$ und $i_{d,soll}$ verglichen, welche aus einem vorgegebenen Soll-Drehmoment $M_{soll}$ berechnet werden. Je nach Regelabweichung liefern die Stromregler 10 passende Spannungen $u_d$ und $u_q$, die in einem Konverter 11 auf Strangspannungen $u_U$, $u_V$, und $u_W$ umgerechnet und mit einem Wechselrichter 12 an der Drehstrommaschine 1 angelegt werden.

Hierbei ist zu beachten, dass ohne zusätzliche Strommessgeräte aus den gemessenen, fehlerhaften Strangströmen $\tilde{\imath}_U$, $\tilde{\imath}_V$ und $\tilde{\imath}_W$ zwar nicht die wahren Strangströme $i_U$, $i_V$, $i_W$ ermittelt werden können; die Korrektur der gemessenen Strangströme über die Korrekturparameter $\alpha$ kann jedoch dazu beitragen, den durch die fehlerhafte Strommessung verursachten Drehmomentrippel zu verringern bzw. gänzlich zu vermeiden, wie nachstehend anhand von bevorzugten Ausführungsvarianten näher beschrieben wird.

Zur Korrektur der gemessenen Strangströme $\tilde{\imath}_U$, $\tilde{\imath}_V$ und $\tilde{\imath}_W$ werden Gleichungen (4)-(6) zu Gleichungen (7)-(9) umgeformt, worin $\alpha_U$, $\alpha_V$, $\alpha_W$ Korrekturparameter für die Verstärkungsfehler und $\beta_U$, $\beta_V$, $\beta_W$ Korrekturparameter für die Offsetfehler bezeichnen.

$$i_U = \frac{1}{k_U}(\tilde{\imath}_U - d_U) = \alpha_U \tilde{\imath}_U + \beta_U \qquad\qquad (7)$$

$$i_V = \frac{1}{k_V}(\tilde{\imath}_V - d_V) = \alpha_V \tilde{\imath}_V + \beta_V \qquad\qquad (8)$$

$$i_W = \frac{1}{k_W}(\tilde{\imath}_W - d_W) = \alpha_W \tilde{\imath}_W + \beta_W \qquad\qquad (9)$$

Der Zusammenhang zwischen den Korrekturparametern $\alpha_U$, $\alpha_V$, $\alpha_W$, $\beta_U$, $\beta_V$, $\beta_W$ und den Verstärkungsfaktoren $k_U$, $k_V$, $k_W$ bzw. den Offsetwerten $d_U$, $d_V$, $d_W$ ist in den Gleichungen (10)-(12) angegeben.

$$\alpha_U = \frac{1}{k_U} \qquad \beta_U = -\frac{d_U}{k_U} \qquad\qquad (10)$$

$$\alpha_V = \frac{1}{k_V} \qquad \beta_V = -\frac{d_V}{k_V} \qquad\qquad (11)$$

$$\alpha_W = \frac{1}{k_W} \qquad \beta_W = -\frac{d_W}{k_W} \qquad\qquad (12)$$

In einem ersten Fall wird von einem reinen Verstärkungsfehler in den Messwerten der Strangströme $\tilde{\imath}_U$, $\tilde{\imath}_V$ und $\tilde{\imath}_W$ ausgegangen. Diese Einschränkung ist für einen Stromsensor 5 sinnvoll, dessen Verstärkungsfehler sich im laufenden Betrieb ändern können, wogegen die Offsetfehler im Betrieb konstant bleiben. Ein solches Verhalten weisen beispielsweise Stromsensoren 5 in Form von Kompensations-Stromwandlern mit einer Spule mit hochpermeablem Kern anstelle eines Hall-Elements auf. In diesem Fall kann der konstante Offsetfehler in einer dem Betrieb der Drehstrommaschine 1 vorangehenden Kalibrierung experimentell ermittelt und entsprechend korrigiert werden. Wenn kein Offsetfehler vorliegt ($d_U = d_V = d_W = 0$ sowie $\beta_U = \beta_V = \beta_W = 0$), können die Strangströme $i_U$, $i_V$, $i_W$ mit den Gleichungen (13)-(15) bestimmt werden.

$$i_U = \alpha_U \tilde{\imath}_U \qquad\qquad (13)$$

$$i_V = \alpha_V \tilde{\imath}_V \qquad\qquad (14)$$

$$i_W = \alpha_W \tilde{\imath}_W \qquad\qquad (15)$$

7

Durch Einsetzen in Gleichung (1) folgt Gleichung (16), welche die modifizierte Kirchhoff'sche Knotenregel darstellt.

$$\alpha_U \tilde{\imath}_U + \alpha_V \tilde{\imath}_V + \alpha_W \tilde{\imath}_W = 0 \qquad (16)$$

Da es prinzipbedingt nicht möglich ist, sämtliche Korrekturparameter $\alpha_U$, $\alpha_V$, $\alpha_W$ zu bestimmen, wird gemäß Gleichung (17) ein Korrekturparameter $\alpha_U$ konstant auf 1 gesetzt.

$$\alpha_U = 1 \qquad (17)$$

Wenn die beiden anderen Korrekturparameter $\alpha_V$, $\alpha_W$ relativ zu dem vorgegebenen Korrekturparameter $\alpha_U$ richtig geschätzt werden, können zwar die wahren Strangströme $i_U$, $i_V$ und $i_W$ nicht exakt bestimmt werden, eine kreisförmige Bahn des Stromraumzeigers $\vec{i}$ der wahren Strangströme $i_U$, $i_V$ und $i_W$ wird aber auch auf eine kreisförmige Bahn des gemessenen und korrigierten Stromraumzeigers $\vec{\tilde{\imath}}$ abgebildet, so dass der durch die fehlerhafte Strommessung verursachte Drehmomentrippel eliminiert wird. Gleichung (17) in Gleichung (16) eingesetzt führt zur linearen, unterbestimmten Gleichung (18) mit zwei Unbekannten $\alpha_V$ und $\alpha_W$, die mit den Messwerten eines einzigen Zeitpunkts nicht eindeutig bestimmbar wären.

$$\begin{bmatrix} \tilde{\imath}_V & \tilde{\imath}_W \end{bmatrix} \begin{bmatrix} \alpha_V \\ \alpha_W \end{bmatrix} = \begin{bmatrix} -\tilde{\imath}_U \end{bmatrix} \qquad (18)$$

Daher werden die Messwerte vieler aufeinanderfolgender Zeitpunkte k verwendet, so dass sich ein überbestimmtes Gleichungssystem, vgl. Gleichung (19), ergibt, worin der zusätzliche Index 0,...,k für die gemessenen Strangströme $\tilde{\imath}_{U,k}$, $\tilde{\imath}_{V,k}$, $\tilde{\imath}_{W,k}$ den k-ten Zeitschritt bezeichnet.

$$\begin{bmatrix} \tilde{\imath}_{V,0} & \tilde{\imath}_{W,0} \\ \tilde{\imath}_{V,1} & \tilde{\imath}_{W,1} \\ \vdots & \vdots & \vdots \\ \tilde{\imath}_{V,k} & \tilde{\imath}_{W,k} \end{bmatrix} \begin{bmatrix} \alpha_V \\ \alpha_W \end{bmatrix} = \begin{bmatrix} -\tilde{\imath}_{U,0} \\ -\tilde{\imath}_{U,1} \\ \vdots \\ \tilde{\imath}_{U,k} \end{bmatrix} \qquad (19)$$

Dieses überbestimmte Gleichungssystem kann mit einem rekursiven Algorithmus gelöst werden, wofür sich insbesondere die Methode der kleinsten Fehlerquadrate eignet. Damit in jedem Zeitschritt k die neuen Messwerte der Strangströme $\tilde{\imath}_{U,k}$, $\tilde{\imath}_{V,k}$, $\tilde{\imath}_{W,k}$ stärker als die vorangehenden Messwerte der Strangströme $\tilde{\imath}_{U,k-1}$, $\tilde{\imath}_{V,k-1}$, $\tilde{\imath}_{W,k-1}$ berücksichtigt werden, wird vorzugsweise ein rekursiver adaptiver Filteralgorithmus verwendet. Hierfür bietet sich insbesondere der rekursive kleinste Fehlerquadrate-Algorithmus mit Vergessensfaktor $\lambda$ ("recursive least squares with forgetting factor") an. Dieser Algorithmus wird für den Zeitschritt k - 1 auf k durch die Gleichungen (20)-(22) bestimmt.

$$p_k = \frac{R_{k-1} a_k}{\lambda + a_k^T R_{k-1} a_k} \qquad (20)$$

$$R_k = \frac{1}{\lambda}\left(R_{k-1} - p_k\, a_k^T\, R_{k-1}\right) \qquad (21)$$

$$\hat{x}_k = \hat{x}_{k-1} + p_k\left(z_k - a_k^T\, \hat{x}_{k-1}\right) \qquad (22)$$

In den Gleichungen (20)-(22) bezeichnet $a_k$ einen Vektor, der als Komponenten die Messwerte der Strangströme $\tilde{i}_{V,k}, \tilde{i}_{W,k}$ aufweist, $\hat{x}_k$ einen Vektor, der als Komponenten die gesuchten Korrekturparameter $\alpha_{V,k}, \alpha_{W,k}$ zum k-ten Zeitschritt aufweist, vgl. Gleichung (23), und $\lambda$ den Vergessensfaktor.

$$a_k = \begin{bmatrix} \tilde{i}_{V,k} \\ \tilde{i}_{W,k} \end{bmatrix} \qquad z_k = -\tilde{i}_{U,k} \qquad \hat{x}_k = \begin{bmatrix} \alpha_{V,k} \\ \alpha_{W,k} \end{bmatrix} \qquad (23)$$

Der Vergessensfaktor $\lambda$ wird in einem Bereich zwischen 0 und 1 gewählt, wobei ein Wert für den Vergessensfaktor $\lambda$ nahe 0 schnelles Vergessen und $\lambda$ = 1 kein Vergessen bedeutet; in der Praxis hat sich ein Wert knapp unter 1 als zweckmäßig herausgestellt. Für den ersten Zeitschritt k = 0 müssen die Matrix $R_{-1}$ und der Vektor $\hat{x}_{-1}$ initialisiert werden; zweckmäßige Werte hierfür sind in Gleichung (24) angegeben.

$$R_{-1} = \begin{bmatrix} 0.1 & 0 \\ 0 & 0.1 \end{bmatrix} \qquad \hat{x}_{-1} = \begin{bmatrix} 1 \\ 1 \end{bmatrix} \qquad (24)$$

Die korrigierten Strangströme i'$_U$, i'$_V$ und i'$_W$ zum k-ten Zeitschritt können nun mit den Gleichungen (25)-(27) bestimmt werden.

$$i'_{U,k} = \tilde{i}_{U,k} \qquad (25)$$

$$i'_{V,k} = \alpha_{V,k}\,\tilde{i}_{V,k} \qquad (26)$$

$$i'_{W,k} = \alpha_{W,k}\,\tilde{i}_{W,k} \qquad (27)$$

Nach kurzer Adaptierungszeit im Regelkreis sind die durch fehlerhafte Strommessung verursachten Drehmomentrippel eliminiert.

Im folgenden wird die Korrektur der gemessenen Strangströme $\tilde{i}_{U,k}, \tilde{i}_{V,k}, \tilde{i}_{W,k}$ beschrieben, wenn sowohl Verstärkungs- als auch Offsetfehler auftreten.

In diesem Fall wird durch Einsetzen der Gleichungen (7)-(9) in Gleichung (1) Gleichung (28) erhalten.

$$\alpha_U\,\tilde{i}_U + \alpha_V\,\tilde{i}_V + \alpha_W\,\tilde{i}_W + (\beta_U + \beta_V + \beta_W) = 0 \qquad (28)$$

Wie zuvor für reine Verstärkungsfehler wird ein Korrekturparameter, hier $\alpha_U$, gleich 1 gesetzt, vgl. Gleichung

(29).

$$\alpha_U = 1 \qquad\qquad (29)$$

Da ein gemeinsamer Offsetfehler auf allen Strangströmen $i_U$, $i_V$, $i_W$ keinen Einfluß auf den Stromraumzeiger hat, wird weiters ein Offsetwerte, hier $\beta_U$, 0 gesetzt, vgl. Gleichung (30).

$$\beta_U = 0 \qquad\qquad (30)$$

Mit den Gleichungen (29) und (30) können zwar die tatsächlichen Strangströme $i_U$, $i_V$ und $i_W$ nicht bestimmt, aber die Auswirkungen auf den Drehmomentrippel günstig beeinflusst werden. Aus Gleichung (28) wird mit den Gleichungen (29) und (30) Gleichung (31) erhalten.

$$\alpha_V \tilde{\imath}_V + \alpha_W \tilde{\imath}_W + (\beta_V + \beta_W) = -\tilde{\imath}_U \qquad\qquad (31)$$

Aus Gleichung (31) ist ersichtlich, dass zwischen den Korrekturparametern $\beta_V$ und $\beta_W$ nicht unterschieden werden kann. Dies bedeutet, dass - im Gegensatz zur Korrektur eines reinen Verstärkungsfehlers - der durch fehlerhafte Strommessung verursachte Drehmomentrippel nicht vollständig eliminiert, aber deutlich reduziert werden kann. Hierzu wird ein neuer Korrekturparameter $\beta_{VW}$ gemäß Gleichung (32) als Summe der Korrekturparameter $\beta_V$ und $\beta_W$ eingeführt.

$$\beta_{VW} = \beta_V + \beta_W \quad \mathrm{bzw.} \quad \beta_V = \beta_W = \frac{\beta_{VW}}{2} \qquad\qquad (32)$$

Gleichung (32) in Gleichung (31) eingesetzt ergibt Gleichung (33), woraus direkt Gleichung (34) folgt.

$$\alpha_V \tilde{\imath}_V + \alpha_W \tilde{\imath}_W + \beta_{VW} = -\tilde{\imath}_U \qquad\qquad (33)$$

$$\begin{bmatrix} \tilde{\imath}_V & \tilde{\imath}_W & 1 \end{bmatrix} \begin{bmatrix} \alpha_V \\ \alpha_W \\ \beta_{VW} \end{bmatrix} = \begin{bmatrix} -\tilde{\imath}_U \end{bmatrix} \qquad\qquad (34)$$

Gleichung (34) stellt eine lineare, unterbestimmte Gleichung mit den drei Unbekannten $\alpha_V$, $\alpha_W$ und $\beta_{VW}$ dar. Durch Verwendung von Messwerten vieler aufeinander folgender Zeitpunkte k kann ein überbestimmtes Gleichungssystem gemäß Gleichung (35) erhalten werden, worin der zusätzliche Index 0,...,k sich wiederum auf den k-ten Zeitschritt bezieht:

$$\begin{bmatrix} \tilde{\imath}_{V,0} & \tilde{\imath}_{W,0} & 1 \\ \tilde{\imath}_{V,1} & \tilde{\imath}_{W,1} & 1 \\ \vdots & \vdots & \vdots \\ \tilde{\imath}_{V,k} & \tilde{\imath}_{W,k} & 1 \end{bmatrix} \begin{bmatrix} \alpha_V \\ \alpha_W \\ \beta_{VW} \end{bmatrix} \begin{bmatrix} -\tilde{\imath}_{U,0} \\ -\tilde{\imath}_{U,1} \\ \vdots \\ \tilde{\imath}_{U,k} \end{bmatrix} \qquad (35)$$

Dieses Gleichungssystem kann erneut durch Anwendung des rekursiven kleinsten Fehlerquadrate-Algorithmus mit Vergessensfaktor A nach Gleichungen (20)-(22) gelöst werden. Für den Vektor der Messwerte $a_k$ und den Vektor der gesuchten Korrekturparameter $\hat{x}_k$ zum k-ten Zeitschritt gilt Gleichung (36).

$$a_k = \begin{bmatrix} \tilde{\imath}_{V,k} \\ \tilde{\imath}_{W,k} \\ 1 \end{bmatrix} \qquad z_k = -\tilde{\imath}_{U,k} \qquad \hat{x}_k = \begin{bmatrix} \alpha_{V,k} \\ \alpha_{W,k} \\ \beta_{VW,k} \end{bmatrix} \qquad (36)$$

Günstige Startwerte für die Matrix $R_{-1}$ und den Korrekturparameter-Vektor $\hat{x}_{-1}$ sind in Gleichung (37) angegeben.

$$R_{-1} = \begin{bmatrix} 0.1 & 0 & 0 \\ 0 & 0.1 & 0 \\ 0 & 0 & 0.1 \end{bmatrix} \qquad \hat{x}_{-1} = \begin{bmatrix} 1 \\ 1 \\ 0 \end{bmatrix} \qquad (37)$$

Die korrigierten Strangströme i'$_U$, i'$_V$ und i'$_W$ zum k-ten Zeitschritt können nun mit den Gleichungen (38)-(40) bestimmt werden.

$$i'_{U,k} \;=\; \tilde{\imath}_{U,k} \qquad\qquad (38)$$

$$i'_{V,k} \;=\; \alpha_{V,k}\tilde{\imath}_{V,k} + \frac{\beta_{VW,k}}{2} \qquad\qquad (39)$$

$$i'_{W,k} \;=\; \alpha_{W,k}\tilde{\imath}_{W,k} + \frac{\beta_{VW,k}}{2} \qquad\qquad (40)$$

Die Recheneinheit 7 übermittelt die korrigierten Strangströme i'$_U$, i'$_V$ und i'$_W$ an die Regeleinrichtung 9, welche somit die Verstärkungs- bzw. Offsetfehler in der Strommessung berücksichtigt und weitestgehend kompensiert. Nach kurzer Adaptierungszeit wird eine deutliche Reduktion der durch fehlerhafte Strommessung verursachten Drehmomentrippel im Betrieb der Drehstrommaschine 1 beobachtet.

**Patentansprüche**

1. Verfahren zur Korrektur von Strangströme ($i_U$, $i_V$, $i_W$) einer Drehstrommaschine (1), wobei mit Verstärkungs- und/oder mit Offsetfehlern behaftete Messwerte der Strangsströme ($\tilde{\imath}_U$, $\tilde{\imath}_V$, $\tilde{\imath}_W$) erfasst werden, die zur Regelung der Strangströme ($i_U$, $i_V$, $i_W$) herangezogen werden, und im Betrieb der Drehstrommaschine (1) aus den Messwerte der Strangströme ($\tilde{i}_U$, $\tilde{i}_V$, $\tilde{i}_W$) Korrekturparameter ($\alpha$; $\alpha_U$, $\alpha_V$, $\alpha_W$, $\beta_U$, $\beta_V$, $\beta_W$) zur Korrektur der Verstärkungs- bzw. Offsetfehler berechnet werden, wobei mit den Korrekturparametern ($\alpha$; $\alpha_U$, $\alpha_V$, $\alpha_W$, $\beta_U$, $\beta_V$, $\beta_W$) korrigierte Strangsströme ($i'_U$, $i'_V$, $i'_W$) bestimmt werden, die an die Regelung der Strangströme ($i_U$, $i_V$, $i_W$) übergeben werden, **dadurch gekennzeichnet, dass** die Korrekturparameter ($\alpha$; $\alpha_U$, $\alpha_V$, $\alpha_W$, $\beta_U$, $\beta_V$, $\beta_W$) mittels eines rekursiven Algorithmus berechnet werden.

2. Verfahren nach Anspruch 1, **dadurch gekennzeichnet, dass** im Fall von reinen Verstärkungsfehlern je ein Korrekturparameter ($\alpha$; $\alpha_U$, $\alpha_V$, $\alpha_W$) pro Strangstrom zur Korrektur der Verstärkungsfehler bestimmt wird, wobei bei Auftreten von Offsetfehlern eine entsprechende Anzahl von Korrekturparametern ($\beta_U$, $\beta_V$, $\beta_W$) zur Korrektur der Offsetfehler bestimmt werden.

3. Verfahren nach Anspruch 1 oder 2, **dadurch gekennzeichnet, dass** zur laufenden Anpassung der Korrekturparameter ($\alpha$; $\alpha_U$, $\alpha_V$, $\alpha_W$, $\beta_U$, $\beta_V$, $\beta_W$) im Betrieb der Drehstrommaschine (1) eine zeitliche Abfolge von Messwerten der Strangströme ($\tilde{i}_{U,k}$, $\tilde{i}_{V,k}$, $\tilde{i}_{W,k}$) verarbeitet wird.

4. Verfahren nach Anspruch 3, **dadurch gekennzeichnet, dass** für die Berechnung der Korrekturparameter ($\alpha$; $\alpha_U$, $\alpha_V$, $\alpha_W$, $\beta_U$, $\beta_V$, $\beta_W$) eine zeitliche Gewichtung der Messwerte der Strangströme ($\tilde{i}_{U,k}$, $\tilde{i}_{V,k}$, $\tilde{i}_{W,k}$) vorgenommen wird, wobei aktuelle Messwerte der Strangsströme ($\tilde{i}_{U,k}$, $\tilde{i}_{V,k}$, $\tilde{i}_{W,k}$) stärker als frühere Messwerte der Strangströme ($\tilde{i}_{U,k-1}$, $\tilde{i}_{V,k-1}$, $\tilde{i}_{W,k-1}$) gewichtet werden.

5. Verfahren nach einem der Ansprüche 1 bis 4, **dadurch gekennzeichnet, dass** als rekursiver Algorithmus eine Methode der kleinsten Fehlerquadrate, vorzugsweise mit einem Vergessensfaktor zur zeitlichen Gewichtung der Messwerte der Strangströme ($\tilde{i}_{U,k}$, $\tilde{i}_{V,k}$, $\tilde{i}_{W,k}$), verwendet wird.

6. Verfahren nach einem der Ansprüche 1 bis 5, **dadurch gekennzeichnet, dass** die korrigierten Strangströme ($i'_U$, $i'_V$, $i'_W$) an eine feldorientierte Regelung der Strangströme ($i_U$, $i_V$, $i_W$) übergeben werden.

7. Vorrichtung zur Korrektur von Strangströmen ($i_U$, $i_V$, $i_W$) einer Drehstrommaschine (1), mit einer Messeinrichtung (6) zum Messen von mit Verstarkungs- und/oder mit Offsetfehlern behafteten Strangströmen ($\tilde{i}_U$, $\tilde{i}_V$, $\tilde{i}_W$) einer Drehstrommaschine (1), und mit einer mit der Messeinrichtung (6) verbundenen Regeleinrichtung (9) zur Regelung der Strangströme ($i_U$, $i_V$, $i_W$), **dadurch gekennzeichnet, dass** die Messeinrichtung (6) mit einer Recheneinheit (7) verbunden ist, welche dazu eingerichtet ist, im Betrieb der Drehstrommaschine (1) aus den Messwerten der Strangströme ($\tilde{i}_U$, $\tilde{i}_V$, $\tilde{i}_W$) mittels eines rekursiven Algorithmus Korrekturparameter ($\alpha$; $\alpha_U$, $\alpha_V$, $\alpha_W$, $\beta_U$, $\beta_V$, $\beta_W$) zur Korrektur der Verstärkungs- bzw. Offsetfehler zu berechnen, wobei die Recheneinheit (7) zur Übertragung korrigierter Strangströme ($i'_U$, $i'_V$, $i'_W$) mit der Regeleinrichtung (9) verbunden ist.

8. Vorrichtung nach Anspruch 7, **dadurch gekennzeichnet, dass** die Messeinrichtung (6) jeweils einem Strang (4) der Drehstrommaschine (1) zugeordnete Stromsensoren (5), insbesondere Kompensationsstromwandler, zum Messen der zugehörigen Strangströme ($i_U$, $i_V$, $i_W$) aufweist.

**Claims**

1. A method for correcting phase currents ($i_U$, $i_V$, $i_W$) of a three-phase machine (1), wherein phase current readings ($\tilde{i}_U$, $\tilde{i}_V$, $\tilde{i}_W$) containing gain errors and/or offset errors are taken, which readings are used for regulating the phase currents ($i_U$, $i_V$, $i_W$), and correction parameters ($\alpha$; $\alpha_U$, $\alpha_V$, $\alpha_W$, $\beta_U$, $\beta_V$, $\beta_W$) for correcting the gain errors and/or the offset errors are calculated from the phase current readings ($\tilde{i}_U$, $\tilde{i}_V$, $\tilde{i}_W$) during operation of the three-phase machine (1), wherein phase currents ($i'_U$, $i'_V$, $i'_W$) corrected by the correction parameters ($\alpha$; $\alpha_U$, $\alpha_V$, $\alpha_W$, $\beta_U$, $\beta_V$, $\beta_W$) are determined, which phase currents are transferred to the regulation of the phase currents ($i_U$, $i_V$, $i_W$), **characterised in that** the correction parameters ($\alpha$; $\alpha_U$, $\alpha_V$, $\alpha_W$, $\beta_U$, $\beta_V$, $\beta_W$) are calculated by means of a recursive algorithm.

2. The method according to claim 1, **characterised in that** in case of mere gain errors one correction parameter ($\alpha$; $\alpha_U$, $\alpha_V$, $\alpha_W$) is determined for correcting the gain errors of each phase current, with a corresponding number of correction parameters ($\beta_U$, $\beta_V$, $\beta_W$) for correcting offset errors being determined should offset errors occur.

3. The method according to claim 1 or 2, **characterised in that** for continuous adjustment of the correction parameters ($\alpha$; $\alpha_U$, $\alpha_V$, $\alpha_W$, $\beta_U$, $\beta_V$, $\beta_W$) during operation of the three-phase machine (1) a temporal sequence of phase current

readings ($\tilde{i}_{U,k}$, $\tilde{i}_{V,k}$, $\tilde{i}_{W,k}$) is processed.

4. The method according to claim 3, **characterised in that** for calculating the correction parameters ($\alpha$; $\alpha_U$, $\alpha_V$, $\alpha_W$, $\beta_U$, $\beta_V$, $\beta_W$) a temporal weighting of the phase current readings ($\tilde{i}_{U,k}$, $\tilde{i}_{V,k}$, $\tilde{i}_{W,k}$) is applied, wherein current phase current readings ($\tilde{i}_{U,k}$, $\tilde{i}_{V,k}$, $\tilde{i}_{W,k}$) are weighted stronger than earlier phase current readings ($\tilde{i}_{U,k-1}$, r$\tilde{i}_{V,k-1}$, r$\tilde{i}_{W,k-1}$).

5. The method according to any one of claims 1 to 4, **characterised in that** a method of least squares, preferably including a forgetting factor for temporal weighting of the phase current readings ($\tilde{i}_{U,k}$, $\tilde{i}_{V,k}$, $\tilde{i}_{W,k}$), is used as the recursive algorithm.

6. The method according to any one of claims 1 to 5, **characterised in that** the corrected phase currents (i'$_U$, i'$_V$, i'$_W$) are transferred to a field-oriented regulation of the phase currents (i$_U$, i$_V$, i$_W$).

7. An apparatus for correcting phase currents (i$_U$, i$_V$, i$_W$) of a three-phase machine (1), having a measuring device (6) for measuring phase currents ($\tilde{i}_U$, $\tilde{i}_V$, $\tilde{i}_W$) of a three-phase machine (1) containing gain errors and/or offset errors, and having a regulating device (9) connected to the measuring device (6) for regulating the phase currents (i$_U$, i$_V$, i$_W$), **characterised in that** the measuring device (6) is connected to a calculating unit (7), which is set up to calculate correction parameters ($\alpha$; $\alpha_U$, $\alpha_V$, $\alpha_W$, $\beta_U$, $\beta_V$, $\beta_W$) for correcting the gain errors and/or the offset errors from the phase current readings ($\tilde{i}_U$, $\tilde{i}_V$, $\tilde{i}_W$) by means of a recursive algorithm during operation of the three-phase machine (1), wherein the calculating unit (7) is connected to the regulating device (9) for transferring corrected phase currents (i'$_U$, i'$_V$, i'$_W$).

8. The apparatus according to claim 7, **characterised in that** the measuring device (6) has current sensors (5), in particular compensation current transformers, associated to one phase (4) each of the three-phase machine (1) for measuring the respective phase currents (i$_U$, i$_V$, i$_W$).

**Revendications**

1. Procédé pour la correction de courants de phase (i$_U$, i$_V$, iw) d'une machine à courant triphasé (1), dans lequel des valeurs de mesure comportant des erreurs d'amplification et/ou de décalage des courants de phase ($\tilde{i}_U$, $\tilde{i}_V$, $\tilde{i}_W$) sont détectées, celles-ci étant prises en compte pour la régulation des courants de phase (i$_U$, i$_V$, i$_W$), et, lors du fonctionnement de la machine à courant triphasé (1), des paramètres de correction ($\alpha$; $\alpha_U$, $\alpha_V$, $\alpha_W$, $\beta_U$, $\beta_V$, $\beta_W$) pour la correction des erreurs d'amplification et/ou de décalage étant calculés à partir des valeurs de mesure des courants de phase ($\tilde{i}_U$, $\tilde{i}_V$, iw), dans lequel des courants de phase corrigés (i'$_U$, i'$_V$, i'$_W$) sont déterminés avec les paramètres de correction ($\alpha$; $\alpha_U$, $\alpha_V$, $\alpha_W$, $\beta_U$, $\beta_V$, $\beta_W$), lesquels paramètres de correction sont transmis à la régulation des courants de phase (i$_U$, i$_V$, i$_W$), **caractérisé en ce que** les paramètres de correction ($\alpha$; $\alpha_U$, $\alpha_V$, $\alpha_W$, $\beta_U$, $\beta_V$, $\beta_W$) sont calculés à l'aide d'un algorithme récursif.

2. Procédé selon la revendication 1, **caractérisé en ce que**, en cas de pures erreurs d'amplification, respectivement un paramètre de correction ($\alpha$; $\alpha_U$, $\alpha_V$, $\alpha_W$) par courant de phase pour la correction des erreurs d'amplification est déterminé, et dans lequel lors de l'apparition d'erreurs de décalage, un nombre correspondant de paramètres de correction ($\beta_U$, $\beta_V$, $\beta_W$) est déterminé pour la correction des erreurs de décalage.

3. Procédé selon la revendication 1 ou 2, **caractérisé en ce que**, pour l'adaptation permanente des paramètres de correction ($\alpha$; $\alpha_U$, $\alpha_V$, $\alpha_W$, $\beta_U$, $\beta_V$, $\beta_W$) lors du fonctionnement de la machine à courant triphasé (1), une suite chronologique de valeurs de mesure des courants de phase ($\tilde{i}_{U,k}$, $\tilde{i}_{V,k}$, $\tilde{i}_{W,k}$) est traitée.

4. Procédé selon la revendication 3, **caractérisé en ce que**, pour le calcul des paramètres de correction ($\alpha$; $\alpha_U$, $\alpha_V$, $\alpha_W$, $\beta_U$, $\beta_V$, $\beta_W$), une pondération en fonction du temps des valeurs de mesure des courants de phase ($\tilde{i}_{U,k}$, $\tilde{i}_{V,k}$, $\tilde{i}_{W,k}$) est effectuée, des valeurs de mesure actuelles des courants de phase ($\tilde{i}_{U,k}$, $\tilde{i}_{V,k}$, $\tilde{i}_{W,k}$) étant plus fortement pondérées que des valeurs de mesure antérieures des courants de phase ($\tilde{i}_{U,k-1}$, $\tilde{i}_{V,k-1}$, $\tilde{i}_{W,k-1}$).

5. Procédé selon l'une des revendications 1 à 4, **caractérisé en ce que**, en guise d'algorithme récursif, une méthode des moindres carrés, de préférence avec un facteur d'oubli, est utilisée pour la pondération en fonction du temps des valeurs de mesure des courants de phase ($\tilde{i}_{U,k}$, $\tilde{i}_{V,k}$, $\tilde{i}_{W,k}$).

6. Procédé selon l'une des revendications 1 à 5, **caractérisé en ce que** les courants de phase corrigés (i'$_U$, i'v, i'w) sont transmis à une régulation à champ orienté des courants de phase ($i_U$, $i_V$, $i_W$).

7. Dispositif pour la correction de courants de phase ($i_U$, $i_V$, $i_W$) d'une machine à courant triphasé (1), avec un dispositif de mesure (6) pour mesurer des courants de phase présentant des erreurs d'amplification et/ou de décalage ($\tilde{i}_U$, $\tilde{i}_V$, $\tilde{i}_W$) d'une machine à courant triphasé (1), et avec un dispositif de régulation (9) en liaison avec le dispositif de mesure (6) pour la régulation des courants de phase ($i_U$, iv, iw), **caractérisé en ce que** le dispositif de mesure (6) est en liaison avec une unité de calcul (7), laquelle est étudiée pour calculer, lors du fonctionnement de la machine à courant triphasé (1), à partir des valeurs de mesure des courants de phase ($\tilde{i}_U$, $\tilde{i}_V$, $\tilde{i}_W$) à l'aide d'un algorithme récursif, des paramètres de correction ($\alpha$; $\alpha_U$, $\alpha_V$, $\alpha_W$, $\beta_U$, $\beta_V$, $\beta_W$) pour la correction des erreurs d'amplification et/ou de décalage, l'unité de calcul (7) étant en liaison avec le dispositif de régulation (9) pour la transmission de courants de phase corrigés ($i'_U$, i'v, i'w).

8. Dispositif selon la revendication 7, **caractérisé en ce que** le dispositif de mesure (6) présente des capteurs de courant (5) respectivement associés à une phase (4) de la machine à courant triphasé (1), en particulier des convertisseurs de courant de compensation, pour mesurer les courants de phase ($i_U$, $i_V$, $i_W$) associés.

Fig. 1

Fig. 2a

Fig. 2b

Fig. 3a

Fig. 3b

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090189553 A1
- JP 2009303283 A
- US 2008265829 A1
- JP 2005318739 A

- DE 4110716 A1
- EP 2058936 A
- JP 2010110067 A